# EUROPEAN PATENT APPLICATION

(11) **EP 4 800 481 A1**
(43) Date of publication of application: **02.09.2026**
(21) Application number: 25160485.6
(22) Date of filing: 27.02.2025
(51) Int. Cl.: G03F 7/20

(54) **EXPOSURE METHOD AND APPARATUS**

(71) Applicant: ASML Netherlands B.V., 5500 AH Veldhoven (NL)
(72) Inventor: ROOBOL, Sander, Bas, 5500 AH Veldhoven (NL); VAN LARE, Marie-Claire, 5500 AH Veldhoven (NL)
(74) Representative: ASML Netherlands B.V.

(57) **Abstract**

A method of exposing a substrate to a patterned radiation beam, the method comprising: providing a patterning device for a multi-field exposure, the patterning device having at least two identical patterns arranged thereon in a scanning direction; determining at least one process control parameter; determining an exposure layout for the substrate based on the at least one process control parameter; and exposing the substrate according to the exposure layout.

## Description

### FIELD

The present invention relates to the field of lithography and semiconductor manufacturing. In particular, it pertains to a method of exposing a substrate to a patterned radiation beam, a method of manufacturing a semiconductor device using said exposure method, a semiconductor device produced thereby, and a lithographic apparatus for carrying out these methods.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

To this end, the pattern of the patterning devices is repeatedly projected onto different portions of the substrate until the whole substrate has been exposed to the electromagnetic radiation. The exposure is carried out using an exposure layout which determines an order in which each portion of the substrate is to be exposed to the electromagnetic radiation. The exposure layout includes exposure fields arranged to form a grid corresponding to an area of the substrate. Each exposure field may, for example, correspond to a size of the pattern projected onto the substrate.

In a conventional lithographic process, the pattern of the patterning device is chosen based on parameters such as design of the ICs to be manufactured, a feature size of elements of the IC, resolution capabilities of the lithographic apparatus. These parameters are considered to obtain an exposure layout which results in the best throughput and yield of the ICs in the lithographic manufacturing process. In other words, before the manufacturing process has started, the exposure layout is optimized to maximize substrate yield (i.e., to minimize unusable edge die), reduce number of exposure fields, etc. Once set, the exposure layout does not change anymore throughout the manufacturing process.

However, in present lithographic processes, the exposure layout does not take into account (individual) properties of each substrate. For example, a surface flatness of a substrate differs from substrate to substrate (wafers) or, more generally, over an area of a single substrate. The unflatness may negatively affect formation of IC features thereon and, hence, lead to faulty ICs, affecting the yield.

### SUMMARY

Therefore, according to a first aspect of the present disclosure there is a method of exposing a substrate to a patterned radiation beam provided.

The method comprises the steps of:
- providing a patterning device for a multi-field exposure, the patterning device having at least two identical patterns arranged thereon in a scanning direction;
- determining at least one process control parameter;
- determining an exposure layout for the substrate based on the at least one process control parameter; and
- exposing the substrate according to the exposure layout.

A full-field exposure refers to a situation where an exposed area on a substrate corresponds to an area corresponding (close) to the maximal possible exposure field of the projection system PS. The full-field exposure in this disclosure may be referred to as a single-field exposure. Consequently, the multi-field exposure field refers to a situation wherein a patterning area of the pattering device corresponds to at least two full-field exposures on the substrate. For example, the patterning device may include 2 or 3 identical patterns forming the patterning area. Then the patterning area is projected onto the substrate using 2 or 3 full-field exposures, respectively.

A scanning direction refers to a direction in which the patterning device or the substrate moves during the exposure process. Alternatively, it may be defined as a path along which a patterned radiation beam is projected onto the substrate, thereby enabling the transfer of the pattern onto the substrate.

In an embodiment, the patterning device has exactly two identical patterns arranged thereon.

The method according to the present invention may be executed on a lithographic apparatus in a process of manufacturing a semiconducting device. In such situation, at least one control parameter maybe the at least one control parameter of the lithographic apparatus.

The at least one process control parameter may be a process variable or a control parameter of an element of the lithographic apparatus.

The disclosed method is beneficial as it allows determining the exposure layout on a substrate-per-substrate basis. In other words, the exposure layout may be adjusted during a semiconductor manufacturing itself. As the at least two patterns are identical, it is not important which of the at least two patterns is used for the exposure of a portion of the substrate. One can, for example, use parameters of the substrate to adjust the exposure layout accordingly and, hence, result in an improved yield.

It is however noted that the optimization of the exposure layout as disclosed herein may not always result in better throughput. In fact, in many cases the throughput will be (slightly) negatively affected by the disclosed method. Nonetheless, this shortcoming is overshadowed by yield improvements achieved.

In an embodiment, the step of determining the exposure layout further may include a step of determining a pattern of the at least two identical patterns according to which a portion of the substrate is to be exposed.

Thus, present method allows one more flexibility in optimizing the exposure layout. In an embodiment, an initial exposure layout may be determined using conventional techniques as described in the prior art. The initial exposure layout may be then further optimized using the method disclosed herein. For example, to determine which pattern of the at least two patterns is to be used for a particular exposure field of the initial exposure layout.

In an embodiment, the at least one process control parameter is a number of exposure steps (moving from field to field) required for exposing the substrate according to a specific exposure layout, and wherein the exposure layout is determined from a plurality of exposure layouts as the exposure layout having the minimal number of required exposure steps.

In its simplest form, the present disclosure allows one to select the exposure layout which resulting in a fastest exposure process of a substrate.

In an embodiment, the step of determining the exposure layout comprises arranging exposures of said at least two identical patterns into a plurality of exposure columns and a plurality of exposure rows, wherein the exposure columns extend in the scanning direction, and wherein (at least some) exposures belonging to a first exposure column of the plurality of exposure columns are shifted in the scanning direction with respect to exposures belonging to a second exposure column of the plurality of exposure columns by an exposure shift. The exposure shift may correspond to a size of any one of the at least two identical patterns in the scanning direction.

The exposures of each of the exposure columns may be multi-field exposures.

Thus, present disclosure allows one to shift each of the exposure columns up and down in the scanning direction. This results in a large number of possible exposure layouts from which one can choose the optimal exposure layout based on the at least one process control parameter.

In an embodiment, the method is performed using a step-and-scan lithographic projection apparatus.

In an embodiment, the exposure layout is based on a combination of the single-field exposure (full-field exposure) and the multi-field exposure.

By combining the multi-field exposures with the single-field exposures, the available set of exposure layout candidates increases significantly. Consequently, the benefits of the herein disclosed method become even more evident.

In an embodiment, the at least one process control parameter includes a parameter of the substrate, a parameter of the pattern, and/or an actuator parameter.

The parameter of the substrate and the actuator parameter may correspond to the control parameters and the parameter of the pattern may correspond to the process variables.

These parameters are readily available from a lithographic apparatus and can be obtained in situ for optimizing the exposure layout as the substrate is placed into the lithographic apparatus. Additionally, also data from external data sources, such as overlay metrology, may be used for optimizing the exposure layout.

In an embodiment, the at least one process control parameter may be used to estimate a residual error between a pre-determined value of the at least one process control parameter and a measured value of the at least one process control parameter.

The residual error refers to the difference between the desired and actual outcome of a patterning or exposure process. These errors typically occur after steps such as alignment, exposure, or development and are critical for determining how accurately a pattern has been transferred onto a substrate. Consequently, optimizing the exposure layout according to the present disclosure to minimize the residual error directly results in an improved yield of the manufacturing process.

In an embodiment, the method may include the step of:
- determining a first exposure layout for the substrate;
- using the at least one process control parameter to determine at least one imaging parameter corresponding to the first exposure layout;
- determining a first residual error due to the determined at least one imaging parameter;
- determining a second exposure layout for the substrate different from the first exposure layout;
- using the at least one process control parameter to determine the at least one imaging parameter for the second exposure layout;
- determining a second residual error due to the determined at least one imaging parameter;
- determining the exposure layout to correspond to the exposure layout having a lower residual error between the first residual error and the second residual error.

In optimizing the exposure process, a tradeoff may be made between achieving minimal residual error and maintaining productivity. Specifically, reducing residual errors may require increased exposure time, potentially impacting throughput. According to the present disclosure, a balance between residual optimization and productivity loss may be determined on a layer-specific basis and customer requirements. As such, the exposure strategy is developed accordingly to achieve an optimal compromise between precision and efficiency.

In a further embodiment, the first imaging parameter and the second imaging parameters are focus parameters and/or aberration parameters of a projection system. Additionally or alternatively, the at least one process control parameter includes an overlay information.

These parameters belong to process variables and directly influence the accuracy at which the pattern is imprinted onto the substrate. Their influence onto the quality of the final is immense thus, reducing the residual error due to the above-mentioned imaging parameters may significantly improve the manufacturing process.

In an embodiment, the at least one process control parameter includes height data of a surface of the substrate.

Surface unflatness of the substrate is a parameter that significantly influences the effectiveness of the exposure process. Unfortunately, prior art methods for optimizing exposure layout cannot use this data (or at least data of an individual substrate). Advantageously, present disclosure allows for using the height data of the substrate when determining the optimal exposure layout.

In an embodiment, the at least one process control parameter includes a critical dimension information.

In an embodiment, the at least one process control parameter further includes at least one of the following: critical dimension uniformity information, local critical dimension uniformity information, local placement error information, and line width roughness information.

All the above-mentioned process control parameters may individually or in combination influence the semiconductor manufacturing process of the lithographic apparatus. The present disclosure allows one to optimize the exposure layout against any one of the above-mentioned process control parameters alone or in combination.

In an embodiment, the method further includes a step of obtaining level sensor data, alignment sensor data, overlay data, and/or calibration data and determining the at least one process control parameter based on the obtained data.

A lever sensor and a alignment sensor may be part of a movement control unit of a lithographic apparatus. An overlay data and the calibration data may be obtained from an exposure station of the lithographic apparatus. Particularly from an overlay sensor and a projection optics actuator of the exposure station, respectively.

According to a second aspect of the present disclosure, there is a method of manufacturing a semiconductor device provided.

The method comprises the steps of:
- receiving a substrate having a radiation-sensitive material thereon;
- using an illumination system to generate a radiation beam;
- allowing at least part of the radiation beam into a projection system comprising a patterning device having at least two identical patterns thereon to generate a patterned radiation beam;
- exposing the substrate to the patterned radiation beam using a method according to the first aspect of the present disclosure; and
- removing a portion of the radiation-sensitive material to form an image of the pattern over the substrate.

In an embodiment, the radiation may be an EUV radiation.

According to a third aspect of the present disclosure, there is a semiconductor device provided. The semiconductor device is produced using a method according to the second aspect of the present disclosure.

According to a forth aspect of the present disclosure there is a lithographic apparatus provided.

The lithographic devices comprises a control unit and a patterning device for a multi-field exposure, the patterning device having at least two identical patterns arranged thereon in a scanning direction, wherein the control unit comprises:
- a receiving sub-unit for receiving at least one process control parameter of the lithographic apparatus;
- a computation sub-unit for determining an exposure layout for a substrate based on the at least one process control parameter; and
- an output sub-unit configured to send a control signal to a substrate table, and wherein the substrate table is configured to move the substrate such that the substrate is exposed according to the determined exposure layout.

In an embodiment, the computation sub-unit may be configured to determine a pattern of the at least two identical patterns according to which a portion of the substrate W is to be exposed based on the received at least one process control parameter.

In an embodiment, the receiving sub-unit may be configured to receive the at least one process control parameter from at least one of the following elements of the lithographic apparatus: a level sensor, an alignment sensor, a projection system calibration unit, and/or an external data source such as a separate metrology system.

In an embodiment, the control unit may be configured to carry out a method according to a first aspect of the present disclosure.

Further advantages of the disclosed invention will become evident in the following.

### BRIEF DESCRIPTION OF THE DRAWINGS

Embodiments of the invention will now be described, by way of example only, with reference to the accompanying schematic drawings, in which:
- Figure 1A depicts a lithographic system comprising a lithographic apparatus and a radiation source;
- Figure 1B depicts a lithographic apparatus according to a second embodiment of the present disclosure;
- Figure 2 depicts a patterning device for a multi-field exposure;
- Figure 3A-3E depict different exposure layouts of a substrate according various embodiments of the present disclosure;

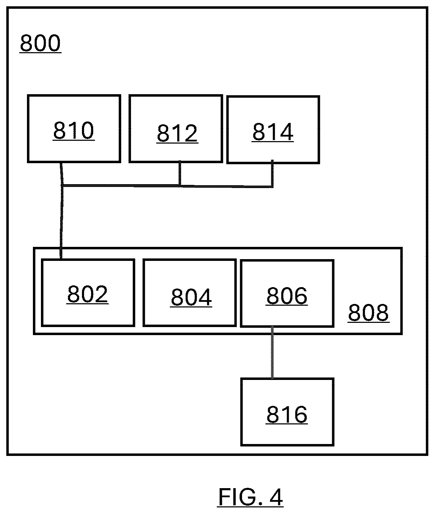

- Figure 4 depicts in a schematic view a lithographic system according to an embodiment of the present disclosure.

### DETAILED DESCRIPTION

The invention will be explained in more detail below with reference to drawings in which illustrative embodiments thereof are shown. The drawings are intended exclusively for illustrative purposes and not as a restriction of the inventive concept which is to cover all modifications, equivalents, and alternatives falling within the scope of the present invention. The scope of the invention is only limited by the definitions presented in the appended claims.

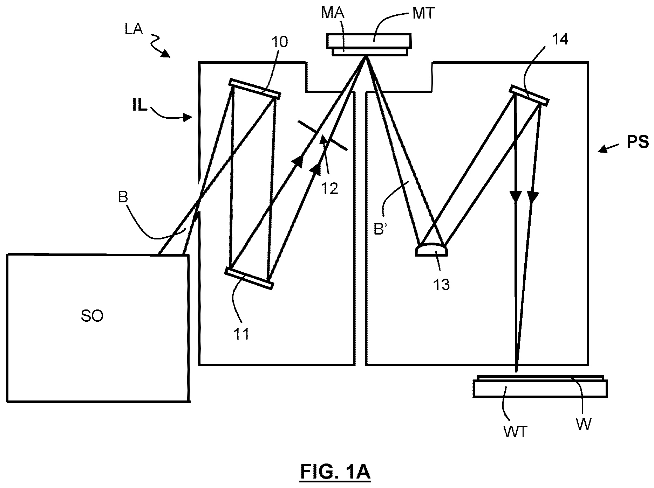

Fig. 1A shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Fig. 1A, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning device MA may be a mask or reticle, which imparts a pattern to a radiation beam transmitted or reflected by the patterning device. Well-known modes of operation include a stepping mode and a scanning mode. As is well known, the projection system PS may cooperate with support and positioning systems for the substrate W and the patterning device MA in a variety of ways to apply a desired pattern to many target portions across the substrate W. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). A direction in which the patterning device MA is scanned is called a scanning direction. The speed and direction of the substrate table WT relative to the patterning device support (e.g., mask table) MT may be determined by the (de-)magnification and image reversal characteristics of the projection system PS. In the scan mode, a maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In step mode, the patterning device support MT and the substrate table WT are kept essentially stationary, while an entire pattern imparted to the radiation beam B is projected onto a target portion C at one time (i.e., a single static exposure). The substrate table WT is then shifted in a X and/or Y direction so that a different target portion C may be exposed.

Combinations and/or variations on the above described modes of use or entirely different modes of use may also be employed. For example, in a step-and-scan mode an area that receives light at any point in time is smaller than the full field. This area is called a slit as described below. During the exposure process, both the substrate W and the patterning device MA are moved (at a substantially constant speed). The patterning device MA is scanned such that each portion of the pattern, corresponding to a size of the slit, gets sequentially illuminated. The reflected radiation from the patterning device MA is directed to the substrate W which is moved in synchronism to project the illuminated portion of the pattern at a correct location on the substrate W.

The largest area which can be exposed in a single exposure of a lithographic apparatus is defined by its scanning field area. The illumination system IL may comprise an illumination slit 12 which determines the scanning field area, i.e. an illuminated area of the patterning device MA per a single scan. This is defined by a width of the illumination slit 12 in the scanning direction (often designated as an X-direction) and the maximum scan length in the orthogonal direction (the non-scanning direction, often designated as a Y-direction) of the same plane (in short, the orthogonal direction Y). In some cases, the die area (the substrate area of the device being manufactured, referred to herein as the substrate field area or substrate region area) is larger than the maximum scanning field area. In this situation, some or all layers of the device need to be exposed on the substrate region (or substrate field) in multiple (e.g., two) separate adjacent exposures. For example: a substrate region twice as large as the maximum scanning field area may be exposed in two exposures: a first exposure using a first reticle comprising a first pattern is used to print a first substrate sub-region (e.g., first half in terms of area on the substrate) of the layer, and a second reticle comprising a second pattern is used to print a second sub-region of the layer (e.g., the second half) on the substrate, adjacent the first half therefore forming the complete layer. The two halves can be referred to as having been "stitched" together, with the process sometimes referred to as intra-die stitching.

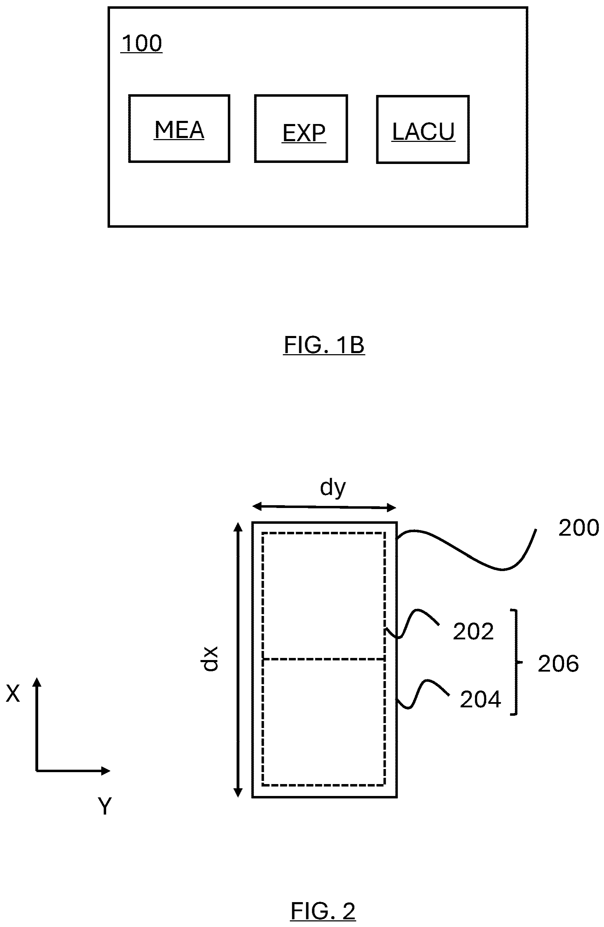

Fig. 1B shows a lithographic apparatus 100. The lithographic apparatus 100 may be the lithographic apparatus LA shown in Fig. 1A. Within the lithographic apparatus 100, a measurement station MEA, an exposure station EXP, a movement control unit LACU may be provided. In this example, each substrate visits the measurement station MEA and the exposure station EXP to have a pattern applied.

The movement control unit LACU may control all movements and measurements of various actuators and sensors to receive substrates W and reticles MA and to implement the patterning operations. LACU may also include signal processing and data processing capacity to implement desired calculations relevant to the operation of the apparatus. In practice, movement control unit LACU may be realized as a system of many sub-units, each handling the real-time data acquisition, processing and control of a subsystem or component within the apparatus.

Before the pattern is applied to the substrate W, the substrate W is processed at the measurement station MEA so that various preparatory steps may be carried out. The preparatory steps may include of the substrate using a level sensor and measuring the position of alignment marks on the substrate using an alignment sensor. The alignment marks are arranged nominally in a regular grid pattern. The apparatus may be of a so-called dual stage type which has two substrate tables, each with a positioning system controlled by the movement control unit LACU. While one substrate on one substrate table WT is being exposed to the pattern radiation beam B', another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. The lithographic apparatus LA may for example is of a so-called dual stage type which has two substrate tables and two stations-an exposure station and a measurement station-between which the substrate tables can be exchanged.

Fig. 2 shows a patterning device 200 for a multi-field exposure. The patterning device 200 may be patterning device MA shown in Fig. 1A. The patterning device 200 shown in Fig. 2 includes two patterns 202, 204 forming together a patterned area 206 of the patterning device 200. A first pattern 202 and a second pattern 204 are arranged adjacent to each other in the scanning direction X. A size of the patterning device 200 may be different in the two dimensions. For example, a size dx of the patterning device 200 in the scanning direction X may be about 12" (inches), while a size dy of the patterning device in the orthogonal direction Y to the scanning direction X may be about 6". In an embodiment, the two patterns 202, 204 may be identical.

Each of the two (identical) patterns 202, 204 may comprise a plurality of patterning features corresponding to a plurality of images to the projected onto the substrate W. For example, the plurality of images may correspond to one or more integrated circuits (ICs) to be formed on the substrate W.

Such patterning device 200 may be for example used in a lithographic apparatus having different reduction (demagnification) factors in the two dimensions. For example, the projection system PS may reduce the patterned EUV radiation beam B' in the scanning direction X by a factor of 8 and in the orthogonal direction Y by a factor of 4. Such demagnification may be achieved using an anamorphic lens, i.e., a lens with different demagnification in the X and Y directions. Consequently, a size of the image (of the two identical patterns combined) on the substrate W would be the same in the scanning direction X and the orthogonal direction Y. This size may correspond to a full-field exposure (also referred herein as a single-field exposure).

To this end, the full-field exposure (or the single exposure) refers to a situation where an exposed area on the substrate W of a single exposure step corresponds to a maximal possible exposure field of the projection system PS.

For example, a size of a patterning area 206 of the patterning device 200 (in the case shown in Fig. 2, the patterning area 206 would correspond to an area of both patterns 202, 204, i.e., an area formed by two squares marked by dashed lines) may be chosen such that its image on the substrate W corresponds to a size of the full-field exposure. This, however, does not mean that the whole patterning area has to be exposed in one step. This may depend on the patterning mode used. For example, in thestep-and-scan mode, the illuminated area of the patterning device 200 will depend on the width of the illumination slit 12 in the scanning direction X. The width of the illumination slit 12 is smaller than the size of the patterning device 200 in the scanning direction X. For example, the width of the illumination slit 12 may be around 3 mm. In such a mode, the illumination slit 12 sequentially illuminates portions of the patterning device 200 along the scanning direction X until the whole patterning area has been imaged onto the substrate W. In the step mode, on the other hand, the whole patterning area may be imaged onto a portion of the substrate W in one exposure step.

Similarly, one can define a half-field exposure. The half-field exposure corresponds to an exposure, wherein the imaged area on the substrate W corresponds to a half of the maximal possible exposure field of the projection system PS.

For example, the patterning device 200 may have the same size in the scanning direction X and the orthogonal direction Y. This size may be, for example, 6". If such mask is used with a projection system having different reduction factors in the two directions, the imaged area on the substrate W will differ in two direction. For example, the reduction factor in the scanning direction X may be 8 and in the orthogonal direction Y may be 4. Then, the size of the imaged area on the substrate W in the scanning direction will be half of the size of the imaged area in the orthogonal direction Y. Thus, if the size of the imaged area in the orthogonal direction Y is chosen to agree to a size of the full-field exposure in this direction, the size of the imaged area in the scanning direction would correspond to a half of the size of the full-field exposure in this direction. Thus, the half-field exposure.

Consequently, in such lithographic apparatuses, one would need to perform more exposures to compensate for a smaller exposure area of the substrate W resulting in a lower throughput. This may be overcome by using a patterning device 200 having twice the size in the scanning direction X compared to the size in the orthogonal direction Y resulting in the full-field exposure. In the example shown in Fig. 2, the size of the patterning area 206 in the scanning direction X (almost agrees with dx) is twice the size of the patterning device 200 in the orthogonal direction Y (almost agrees with dy), as explained above. Thus, both the first pattern 202 and the second pattern 204 will be imaged onto the substrate W as two half-field exposures, which can be seen as one full-field exposure. Such patterning device 200 will be referred herein as a patterning device for a multi-field exposure or the multi-field patterning device (as it will be evident from further below).

We note that although the patterning device 200 is shown in Fig. 2 having two identical patterns 202, 204, this is not limiting. The patterning device 200 may have more than two identical patterns arranged thereon in the scanning direction X. For example, the patterning device may have 3 or 4 or 5 identical patterns arranged in the scanning direction X. In general, the patterning device may have at least 2 identical patterns arranged thereon in the scanning direction.

The two patterns 202, 204 may be identical but this is not obligatory. In the case when a size of the integrated circuit to be manufactured cannot fit into one of the two patterns 202, 204, it may be extended onto the other one of the two patterns 202, 204.

However, the same patterning device 200 having double the size in the scanning direction may be also use in lithographic apparatus having the same reduction factor in the two directions X, Y. For example, the reduction factor may be 4 in both directions. In such apparatuses, the size dx of the patterning device 200 is twice the size of the full-field in this direction. Hence, a multi-field exposure. The patterning area 206 of the patterning device 200 cannot be projected onto the substrate W in one exposure step but two full-field exposures are necessary for this action. In an example, in a first full-field exposure step, the first pattern 202 may be projected onto the substrate W and in a subsequent exposure step, the second pattern 204 may be projected onto the substrate W using a second full-field exposure.

We also note that if there are more than two identical patterns on the patterning device 200 each of these patterns may be projected onto the substrate W using one full-field exposure. Thus, if the patterning device has 3 or 4 or 5 identical patterns, each of these may be exposed using one full-field exposure per pattern.

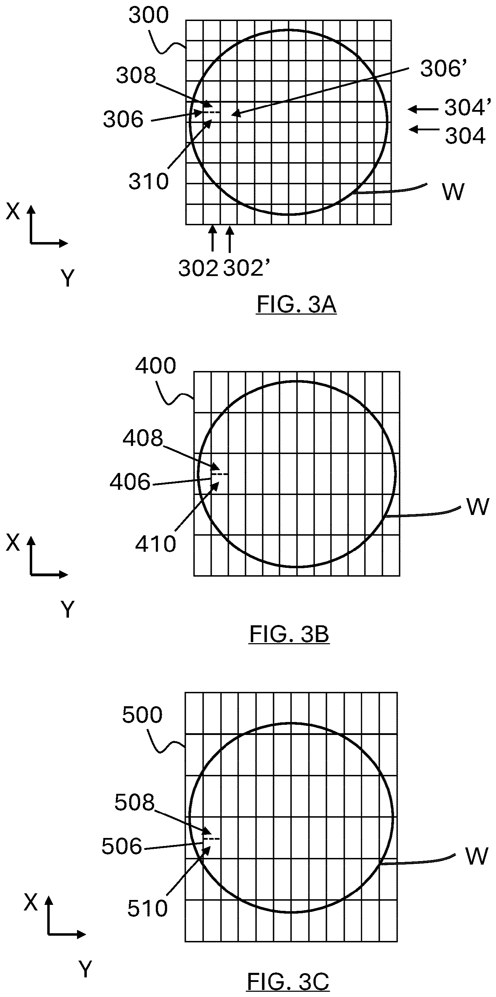

During the exposure process, the whole area of the substrate W is exposed to the patterned EUV radiation B'. This is shown in Figs 3A-3E. These figures show an exposure layout 300-700 of a substrate W. An exposure layout defines an order in which each portion of the substrate W is exposed to the patterned EUV radiation beam B'. Particularly, the full-fields exposures may be used for this purpose to maximize the throughput. The exposure layout is optimized to maximize a substrate yield (i.e., to minimize unusable edge die), ensure precise alignment for multi-layer patterning, reduce number of steps from field to field during an exposure, etc. It is set before the manufacturing process has started and does not change anymore.

The exposure layout 300 may comprise a number of exposure columns 302,302' and a number of exposure rows 304,304'. Each exposure column 302,302' and exposure row 304,304' may comprise a number of full-field exposures 306, 306'. In the patterning process, the projection system PS may expose the full-field exposures 306,306' in a row-to-row manner such that all exposure fields belonging to one exposure row 304,304' are executed before moving to the following exposure row 304, 304'. In an example, the projection system PS may first perform full-field exposures of a first exposure row 304 following the orthogonal direction Y (i.e., exposing first a first full-field exposure 306 followed by exposing a second full-field exposure 306'). Once the exposures of the first exposure row 304 has been carried out, the projection system PS may perform exposures of a second exposure row 304'. The order in which the exposures are carried out in the second exposure row 304', may be reversed to facilitate a substrate movement in the process, i.e. full-field exposures of the second exposure row 304' may be performed in an opposite direction to the orthogonal direction Y (i.e., from the right side of Fig. 3A towards the left side of Fig. 3A).

Each of the full-field exposures 306,306' may comprise an image of the whole patterning device MA if the size of the patterning device MA is arranged to correspond to the full-field exposure of the projection system PS. In the case of the multi-field patterning device 200, depending on the reduction factors of the projection system PS, the patterns 202, 204 may be exposed as two half-field exposures or two full-field exposures.

Fig. 3A shows a case when the two patterns 202, 204 are projected as the two half-field exposures 308, 310, i.e. using the projection system PS having different reduction factors in the two directions X, Y, as explained above. For example, the first pattern 202 may be projected onto a first half-field exposure 308 while the second pattern 204 may be projected onto a second half-field exposure 310. The two half-field exposures 308, 310 form one full-field exposure 306 of the exposure layout 300.

When the multi-field patterning device 200 is used with a projection system PS having the same reduction factors in the two directions X, Y (e.g. the reduction factor of 4), the two patterns 202, 204 can no longer be exposed using one full-field exposure step but rather form two full-field exposures. This is shown in Figs 3B and 3C.

Exposure layouts 400, 500 of the substrate W include exposure columns and exposure rows like in the case of the exposure layout 300 shown in Fig. 3A, however, each exposure field 406, 506 corresponds to the double-field exposure. For each double-field exposure 406, 506, the projection system needs to project the first pattern 202 using a first full-field exposure 408, 508 and subsequently, the second pattern 204 using a second full-field exposure 410, 510.

An interesting scenario occurs when the two patterns 202, 204 are identical. In such a case it is no longer important whether the first full-field exposure 408, 508 (the second full-field exposure 410, 510) is an image of the first pattern 202 or the second pattern 204. Consequently, by aligning the first-full exposure 408 shown in Fig. 3B with the second pattern 204 instead of the first pattern 202 one arrives to the exposure layout shown in Fig. 3C and vice versa (i.e. by aligning the first-full exposure 508 shown in Fig. 3C with the second pattern 204 instead of the first pattern 202 one arrives to the exposure layout shown in Fig. 3B).

This leads to an advantage as the exposure layout 300, 400 may be changed during the manufacturing process itself on a substrate per substrate basis, i.e. by in situ deciding whether to use the first pattern 202 or the second pattern 204 to expose a particular portion of the substrate W.

In an example, one can take into account data of the level sensor to obtain a height map of a surface of the substrate W to determine whether the exposure layout 400 shown in Fig. 3B or the exposure layout 500 shown in Fig. 3C is more appropriate for the substrate W. By analyzing the substrate's surface characteristics, one can select the layout that positions the smallest IC features away from the rougher regions. This minimizes exposure errors and reduces the risk of IC failure.

However, many other parameters may be used independently or in combination when deciding which exposure layout 400, 500 to select between the two.

For example, at least one process control parameter may be used to determine the optimal exposure layout. In this disclosure, a process control parameter refers to any process variable, such as overlay parameters and an focus position, and/or to any control parameter such as parameters of substrate stage actuator and projection optics actuators.

Consequently, a method of exposing a substrate to a patterned radiation beam is proposed. The method comprises the following steps:
- providing the patterning device 200 for the multi-field exposure, the patterning device having at least two identical patterns 202, 204 arranged thereon in the scanning direction X;
- determining at least one process control parameter;
- determining an exposure layout for the substrate W based on the at least one process control parameter; and
- exposing the substrate W according to the exposure layout.

Thus, the step of determining the exposure layout may include a step of determining a pattern of the at least two identical patterns 202, 204 according to which a portion of the substrate W is to be exposed.

Additionally, the at least one process control parameter may be a number of exposure steps required for exposing the substrate according to a specific exposure layout, and wherein the exposure layout is determined from a plurality of exposure layouts as the exposure layout having the minimal number of required exposure steps.

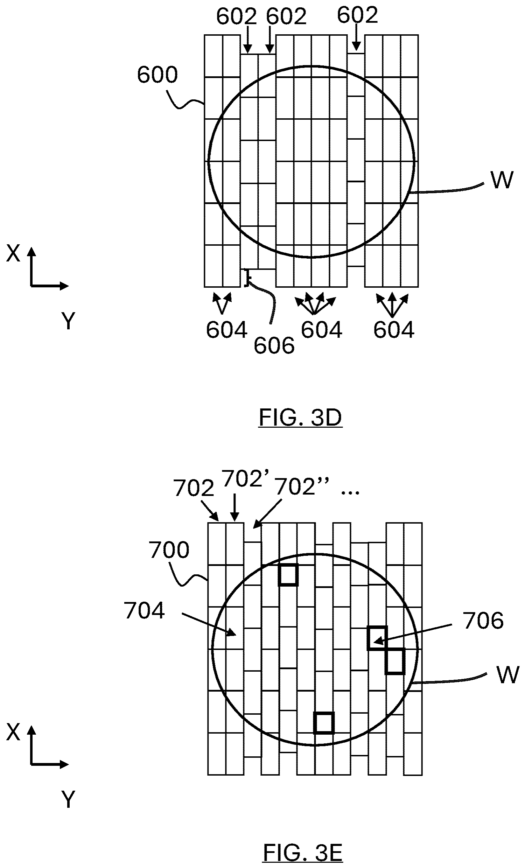

Nonetheless, exposure layouts 400, 500 shown in Figs 3B and 3C are not the only two available options. One can, for example, combine the two. One such example is shown in Fig. 3D.

Fig. 3D shows an exposure layout 600 for a substrate W, wherein the exposure layout 600 has first columns 602 according to the exposure layout 400 shown in Fig. 3B and having second columns 604 according to the exposure layout 500 shown in Fig. 3C. Similarly as above, the best combination of the first columns 602 and the second columns 604 may be selected based on the at least one process control parameter. As it can be seen from Fig. 3D, the double-field exposures of the first columns 602 are shifted in the scanning direction X by an exposure shift 606. The exposure shift may correspond to a size of any one of the at least two identical patterns 202, 204 in the scanning direction. This value may correspond to a size of the full-field exposure in the scanning direction X.

Consequently, the step of determining the exposure layout according to present disclosure may comprise arranging the at least two identical patterns 202, 204 into a plurality of exposure columns 602, 604 and a plurality of exposure rows, wherein the exposure columns extend in the scanning direction X, and wherein the at least two identical patterns 202, 204 of a first exposure column 602 of the plurality of exposure columns 602, 604 are shifted in the scanning direction X with respect to the at least two identical patterns 202, 204 of a second exposure column 604 of the plurality of exposure columns 602, 604 by the exposure shift 606.

Furthermore, one can also combine the multi-field exposures with the single-field exposure (or the full-field exposure) of any one of the at least two identical patterns 202, 204.

This is illustrated in an exposure layout 700 for the substrate W, shown in Fig. 3E. The exposure layout 700 comprises a plurality of exposure columns 702, 702', 702",.... However, unlike the exposure layout 600 shown in Fig. 3D, the exposure layout 700 includes combination of the multi-field exposures 704 and the single-field exposures 706. The multi-field exposures 704 are depicted in Fig. 3E by rectangles while the single-field exposures are depicted with bolded squares for a better visibility.

Consequently, according to the present description one can further optimize the exposure layout on a substrate-per-substrate basis by combining the multi-field exposures 704 and the single-field exposures 706 to form exposure columns 702, 702', 702" as explained above. It is however noted that the optimization of the exposure layout as disclosed herein may not always result in a more efficient productivity. In fact, in many cases the productivity will be (slightly) negatively affected by the disclosed method. Nonetheless, this shortcoming is overshadowed by yield improvements achieved.

The optimization may be based on one or more process control parameters as stated above. Each of these parameters may influence (to a varying extent) the quality, resolution and repeatability of pattern transfer onto the substrate W.

For example, the at least one process control parameter may include a parameter of the substrate, a parameter of the pattern, and/or an actuator parameter. In one example, a substrate flatness affects focus uniformity, which is critical for a high-resolution lithography. Therefore, the at least one process control parameter may include using height data of a surface of the substrate W. The height data of the substrate W may be obtained using the measurement station MEA of the lithographic apparatus LA as explained above.

The parameters of a pattern 202, 204 are also of importance. These include a critical dimension (CD), an overlay information, critical dimension uniformity information, local critical dimension uniformity information, local placement error information, and line width roughness information to name a few.

The parameters of the pattern may be combined with the parameters of the substrate. For example, the substrate flatness may be combined with the critical dimension information. For example, one can optimize exposure layout such that the smallest features of the pattern 202, 204 are as much as possible moved away from rougher portions of the substrate W.

Additionally or alternatively, one may optimize the exposure layout such that the critical dimension uniformity is improved and/or that the local critical dimension uniformity information is improved or within an acceptable limit. The possibilities are vast.

Additionally or alternatively, the actuator parameters are also of importance. The actuator parameters may include actuators of the substrate table WT and actuators of the positioning system PS. These actuators ensure precise positioning of the substrate W and projection optics directly influencing a correctness of the transfer of a pattern of a patterning device onto the substrate.

For example, the multi-field exposures require that the actuators move over larger distances in the scanning direction X due to larger size of the multi-field exposure in this direction. This may lead to a smaller resolution of the actuators in this direction such that the position precision is lower compared to the single-field exposure. Thus, if the substrate parameters are particularly poor in a certain portion of the substrate W, the single-field exposure may be desired in this region as the actuators may more accurately move the substrate table and/or projection optics.

The at least one process control parameter may be obtained using level sensor data, alignment sensor data, overlay data, calibration data and/or data from external sources such as overlay metrology.

A level sensor and an alignment sensor may be part of the movement control unit LACU of the lithographic apparatus LA.

In an example, the at least one process control parameter may be used to estimate a residual error between a pre-determined value of the at least one process control parameter and a measured value of the at least one process control parameter. The predetermined value may be a desired value of the at least one process control parameter. The residual error can be analyzed to assess whether the imprinted pattern meets the required specifications.

Thus, the above-disclosed optimization of the exposure layout may be used to minimize the residual error.

This may be carried out by:
- determining a first exposure layout for the substrate;
- using the at least one process control parameter to determine at least one imaging parameter corresponding to the first exposure layout;
- determining a first residual error due to the determined at least one imaging parameter;
- determining a second exposure layout for the substrate different from the first exposure layout;
- using the at least one process control parameter to determine the at least one imaging parameter for the second exposure layout;
- determining a second residual error due to the determined at least one imaging parameter; and
- determining the exposure layout to correspond to the exposure layout having a lower residual error between the first residual error and the second residual error.

In an example, the first imaging parameter and the second imaging parameters may be focus parameters and/or aberration parameters of the projection system PS.

The above-disclosed method for determining an exposure layout for a substrate may be used for producing a semiconductor device.

The method of manufacturing a semiconductor device comprises the steps of:
- receiving a substrate having a radiation-sensitive material thereon;
- using an illumination system to generate a radiation beam;
- allowing at least part of the radiation beam into a projection system comprising a patterning device having at least two identical patterns thereon to generate a patterned radiation beam;
- exposing the substrate to the patterned radiation beam using the method of determining the exposure layout disclosed above; and
- removing a portion of the radiation-sensitive material to form an image of the pattern over the substrate.

Additionally, the radiation may be an EUV radiation. Particularly, EUV radiation generated by the radiation source SO shown in Fig. 1A.

The present disclosure also relates to a semiconductor device fabricated using the aforementioned method.

The method for determining the exposure layout may be, for example, executed using a lithographic apparatus 800. The lithographic apparatus 800 may be the lithographic apparatus shown in Fig. 1A or Fig. 1B and having a patterning device for a multi-field exposure 200 as shown in Fig. 2.

The lithographic apparatus may comprise a control unit 808. The controlling unit 808 may be configured to determine the optimal exposure layout for a particular substrate W as disclosed above. The control unit 808 may comprise a receiving sub-unit 802, a computation sub-unit 804, and an output sub-unit 806.

The receiving sub-unit 802 may be configured to receive the at least one process control parameter of the lithographic apparatus 800. To this end, the receiving sub-unit may be in communication with a measurement station 810, an exposure station 812, and a movement control unit 814. The measurement station 810, the exposure station 812, and the movement control unit 814 may be corresponding elements shown in Fig. 1B.

Additionally or alternatively, the receiving sub-unit 802 may be configured to receive the at least one process control parameter from at least one of the following elements of the lithographic apparatus 800: a level sensor, an alignment sensor, and/or a projection system calibration unit.

The level sensor may be a part of the measurement station 810, and the alignment sensor and the projection system calibration unit may be parts of the exposure station 812.

The computation sub-unit 804 may be configured to determine an optimal exposure layout for the substrate W based on the at least one process control parameter. The computation sub-unit 804 may execute the method disclosed above to determine the most optimal exposure layout. For example, the computation sub-unit 804 may use the at least one process control parameter to minimize a residual error between a pre-determined value of the at least one process control parameter and a measured value of the at least one process control parameter.

For example, the computation sub-unit 804 may be configured to determine a pattern of the at least two identical patterns according to which a portion of the substrate W is to be exposed based on the received at least one process control parameter.

Furthermore, the computation sub-unit 804 may combine a plurality of process control parameters to obtain an exposure layout having the smallest overall residual error.

The output sub-unit 806 may be configured to send a control signal to a substrate table 816, more precisely to an actuator configured to move the substrate table 816, to move the substrate W such that the substrate W is exposed according to the determined exposure layout.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of exposing a substrate to a patterned radiation beam, the method comprising:
• providing a patterning device for a multi-field exposure, the patterning device having at least two identical patterns arranged thereon in a scanning direction;
• determining at least one process control parameter;
• determining an exposure layout for the substrate based on the at least one process control parameter; and
• exposing the substrate according to the exposure layout.

2. The method according to claim 1, wherein the process control parameter may be a process variable or a control parameter of an element of a lithographic apparatus.

3. The method according to claim 1 or claim 2, wherein the step of determining the exposure layout further includes a step of:
• determining a pattern of the at least two identical patterns according to which a portion of the substrate is to be exposed.

4. The method according to any one of the preceding claims, wherein the at least one process control parameter is a number of exposure steps required for exposing the substrate according to a specific exposure layout, and wherein the exposure layout is determined from a plurality of exposure layouts as the exposure layout having the minimal number of required exposure steps.

5. The method according to any one of the preceding claims, wherein the step of determining the exposure layout comprises arranging exposures of said at least two identical patterns into a plurality of exposure columns and a plurality of exposure rows, wherein the exposure columns extend in the scanning direction, and wherein (at least some) exposures belonging to a first exposure column of the plurality of exposure columns are shifted in the scanning direction with respect to exposures belonging to a second exposure column of the plurality of exposure columns by an exposure shift.

6. The method according to any one of the preceding claims, wherein the exposure shift corresponds to a size of any one of the at least two identical patterns in the scanning direction.

7. The method according to any one of the preceding claims, wherein the method is performed using a step-and-scan lithographic projection apparatus.

8. The method according to any one of the preceding claims, wherein the exposure layout is based on a combination of a single-field exposure and the multi-field exposure.

9. The method according to claim 8, wherein the multi-field exposure is an exposure of the at least two identical patterns and the single-field exposure is an exposure of any one of the at least two identical patterns.

10. The method according to any one of the preceding claims, wherein the at least one process control parameter includes a parameter of the substrate, a parameter of the pattern, and/or an actuator parameter.

11. The method according to any one of the preceding claims, wherein the at least one process control parameter is used to estimate a residual error between a pre-determined value of the at least one process control parameter and a measured value of the at least one process control parameter.

12. The method according to claim 11, wherein the step of determining the exposure layout includes arranging the exposures such to minimize the residual error.

13. The method according to claim 12, wherein the method includes the step of:
• determining a first exposure layout for the substrate;
• using the at least one process control parameter to determine at least one process variable corresponding to the first exposure layout;
• determining a first residual error due to the determined at least one process variable;
• determining a second exposure layout for the substrate different from the first exposure layout;
• using the at least one process control parameter to determine the at least process variable for the second exposure layout;
• determining a second residual error due to the determined at least one process variable;
• determining the exposure layout to correspond to the exposure layout having a lower residual error between the first residual error and the second residual error.

14. The method according to claim 13, wherein the first imaging parameter and the second imaging parameters are focus parameters and/or aberration parameters of a projection system.

15. The method according to any one of the preceding claims, wherein the at least one process control parameter includes height data of a surface of the substrate.

16. The method according to any one of the preceding claims, wherein the at least one process control parameter includes an overlay information.

17. The method according to any one of the preceding claims, wherein the at least one process control parameter includes a critical dimension information.

18. The method according to any one of the preceding claims, wherein the at least one process control parameter further includes at least one of the following: critical dimension uniformity information, local critical dimension uniformity information, local placement error information, and line width roughness information.

19. The method according to any one of the preceding claims, wherein the method further includes a step of:
• obtaining level sensor data, alignment sensor data, overlay data, and/or calibration data and determining the at least one process control parameter based on the obtained data.

20. A method of manufacturing a semiconductor device comprising the steps of:
• receiving a substrate having a radiation-sensitive material thereon,
• using an illumination system to generate a radiation beam;
• allowing at least part of the radiation beam into a projection system comprising a patterning device having at least two identical patterns thereon to generate a patterned radiation beam;
• exposing the substrate to the patterned radiation beam using a method according to any one of the preceding claims; and
• removing a portion of the radiation-sensitive material to form an image of the pattern over the substrate.

21. The method according to claim 20, wherein the radiation is an EUV radiation.

22. A semiconductor device produced using a method according to claim 20 or claim 21.

23. A lithographic apparatus comprising a control unit and a patterning device for a multi-field exposure, the patterning device having at least two identical patterns arranged thereon in a scanning direction, wherein the control unit comprises:
• a receiving sub-unit for receiving at least one process control parameter of the lithographic apparatus,
• a computation sub-unit for determining an exposure layout for a substrate based on the at least one process control parameter; and
• an output sub-unit configured to send a control signal to a substrate table, and wherein the substrate table is configured to move the substrate such that the substrate is exposed according to the determined exposure layout.

24. The lithographic apparatus according to claim 23, wherein the computation sub-unit is configured to determine a pattern of the at least two identical patterns according to which a portion of the substrate W is to be exposed based on the received at least one process control parameter.

25. The lithographic apparatus according to claim 23 or claim 24, wherein the receiving sub-unit is configured to receive the at least one process control parameter from at least one of the following elements of the lithographic apparatus: a level sensor, an alignment sensor, and/or a projection system calibration unit.

26. The lithographic apparatus according to any of any one of claims 23-25, wherein the control unit is configured to carry out a method according to any one of claims 1-19.
